# FASCICULE DE BREVET EUROPEEN

(11) **EP 0 709 886 B1**
(45) Date de publication et mention de la délivrance du brevet: **28.06.2000**
(21) Numéro de dépôt: 95402404.8
(22) Date de dépôt: 26.10.1995
(51) Int. Cl.: H01L 23/498, H01L 23/492

(54) **Film conducteur anisotrope pour la microconnectique**
Anisotropische Leiterschicht für Mikroverbindungen
Anisotropic film conductor for microconnections

(30) Priorité: 28.10.1994 FR 9412961
(43) Date de publication de la demande: 01.05.1996
(73) Titulaire: COMMISSARIAT A L'ENERGIE ATOMIQUE, 75015 Paris Cédex 15 (FR)
(72) Inventeur: Caillat, Patrice, F-38130 Echirolles (FR)
(74) Mandataire: Dubois-Chabert, Guy

(56) Documents cités:
- EP-A- 0 213 774
- EP-A- 0 308 980
- EP-A- 0 327 399
- EP-A- 0 560 072
- US-A- 4 954 878
- US-A- 5 060 844

## Description

### Domaine technique

La présente invention se rapporte au domaine de la microconnectique, où se pose le problème de connecter un substrat actif ou passif à des puces ou des circuits intégrés. Pour réaliser ce type de connexion, il existe quatre grandes familles de méthode :
- le montage par fil, technique encore appelée en terminologie anglo-saxonne "Wire-bonding",
- le montage de la puce sur ruban intermédiaire, également appelé TAB (abréviation de la terminologie anglo-saxonne "Tape automatic bonding")
- la technique dite de "Flip-chip", ou brasure des plots d'entrée-sortie de la puce sur les plots correspondants du substrat par l'intermédiaire de microbossages fusibles (encore appelés billes),
- le montage de la puce et du substrat avec un film intermédiaire conducteur anisotrope qui assure la conduction électrique suivant la direction Z, perpendiculaire aux surfaces de la puce et du substrat, et un bon isolement électrique dans un plan perpendiculaire à cette direction Z.

D'un point de vue qualité du contact obtenu, la technique dite de "Flip-chip" reste du fait de la limitation de la longueur de connexion obtenue, la technique préférée. Par contre, le procédé de mise en oeuvre est long et coûteux puisqu'il nécessite au minimum deux niveaux de lithographie dédiée pour définir l'emplacement des billes.

Le concept de film conducteur anisotrope, auquel se rapporte la présente invention, est très intéressant puisqu'il permet de supprimer la lithographie dédiée à chaque application.

Un domaine d'utilisation de cette technique est par exemple celui des écrans plats, où il faut établir une connexion entre des puces de silicium et des écrans à cristaux liquides. Le film conducteur utilisé est alors le plus souvent une colle époxy chargée, qui en se réticulant met en contact en direction Z les charges conductrices et les plots de connexion.

### Etat de la technique

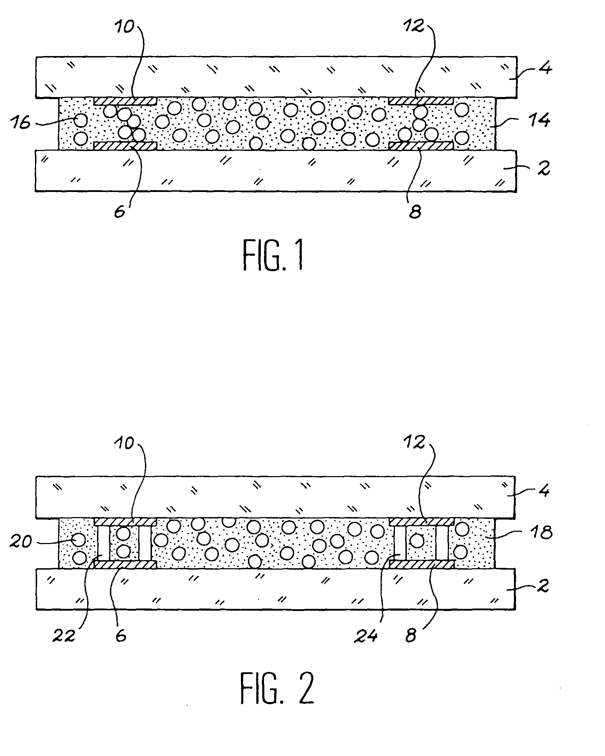

Un premier type de film conducteur anisotrope connu est celui illustré sur la figure 1, où un contact électrique est établi entre un substrat 2 et une puce 4, présentant respectivement des plots de contact 6, 8 et 10, 12, le contact étant assuré par l'intermédiaire d'une matrice polymère 14 possédant un fort retrait à la réticulation, et dans laquelle sont noyées des billes 16 présentant une couche superficielle d'or ou d'argent ou de nickel. On obtient le contact par écrasement des billes incorporées dans la matrice 14, l'écrasement étant soit rapporté de l'extérieur, mécaniquement, soit obtenu par la réticulation de la colle elle-même, qui présente alors un retrait. Dans tous les cas, la résistance de contact obtenue est relativement élevée et, surtout, non reproductible.

Un autre type de liaison par film conducteur anisotrope est illustré sur la figure 2, où les références 2, 4, 6, 8, 10, 12 ont la même signification que sur la figure 1, et où la référence 20 désigne des billes fusibles ou recouvertes d'un matériau fusible, incorporées dans une matrice polymère 18 supportant les hautes températures. Par pression et/ou élévation de température à plusieurs centaines de degrés (par exemple 350°C), le matériau fusible des billes fond, ce qui permet d'établir des contacts 22, 24 entre les plots en regard 6, 10 et 8, 12 du substrat et de la puce. Signalons que la structure représentée sur la figure 2 n'est qu'une interprétation grossière de ce qui se passe effectivement lors de l'application de la pression et/ou de la température élevée. Il est très difficile d'assurer une brasure des billes à travers le film polymère par simple pression-chauffage, puisque le polymère présent en surface peut rapidement empêcher toute soudure correcte des billes entre elles ou sur les plots. Dans la plupart des cas, l'amélioration apportée par cette technique provient de la grande plasticité du matériau fusible qui, en se déformant, permet d'assurer un peu mieux la présence d'un contact électrique, par ailleurs d'assez mauvaise qualité.

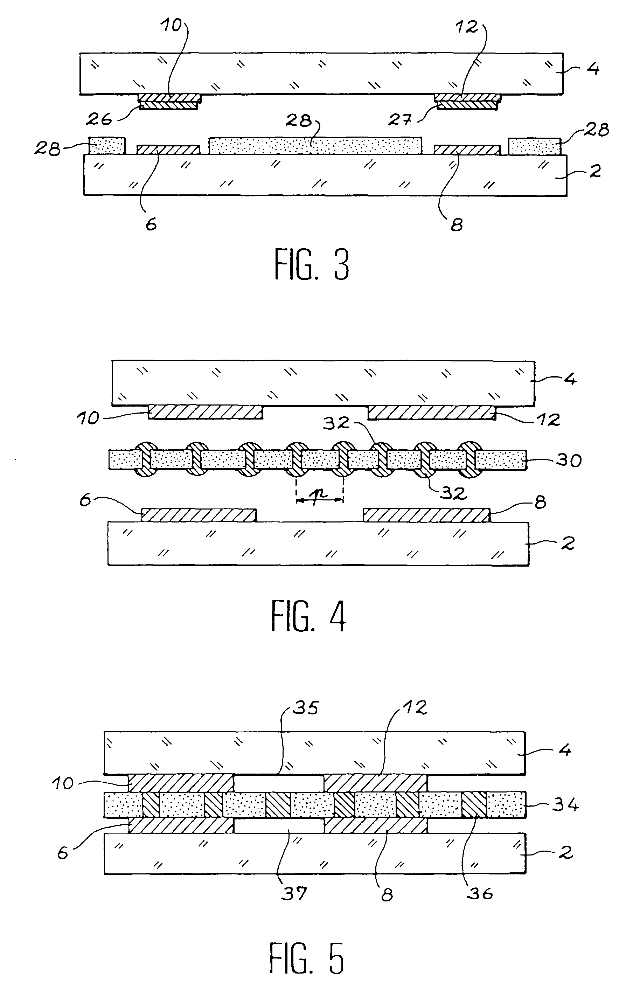

Une autre technique, illustrée sur la figure 3, consiste à déposer sur les plots 10, 12 de la puce 4 une couche 26, 27 d'un matériau fusible, et entre les plots 6, 8 du substrat 2, une couche 28 de polyimide. Les deux parties sont ensuite assemblées par application d'une pression et élévation à une température d'environ 350°C. L'inconvénient de ce genre de technique est qu'il faut des masques d'ouverture au-dessus des plots, pour déposer d'une part le matériau fusible et, d'autre part, le matériau polyimide. On perd donc le côté universel du film conducteur anisotrope.

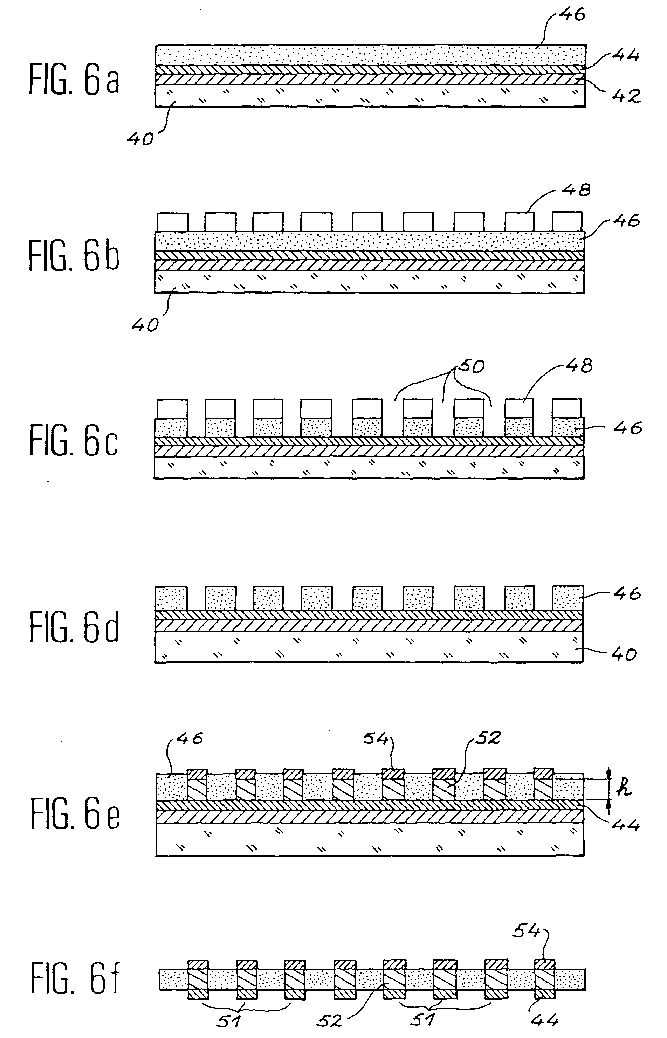

Enfin, on rencontre également la technique VIS (abréviation de "Vertical Interconnection Sheet") qui consiste, comme illustré sur la figure 4, à établir une liaison entre les plots 10, 6 et 12, 8 par l'intermédiaire d'un film polyimide 30 gravé, dans les ouvertures duquel on a déposé, par croissance électrolytique d'or des "clous" 32 débordants. Le problème est que les procédés d'obtention du film avec "clous" conduit à des pas p entre les "clous" relativement importants (de l'ordre de 40 µm) et que, par ailleurs, la liaison électrique par contact des clous d'or débordants ne permet pas d'adhérence possible du film polyimide sur la surface de la puce. Un procédé voisin est décrit dans le brevet US-A-5 304 460, illustré sur la figure 5, où on positionne entre la puce 4 et le substrat 2 un film polymère gravé 34 dans les trous duquel on a évaporé un matériau fusible 36. Ensuite, par compression les clous 36 en matériau fusible sont écrasés sur les plots 6, 10 et 8, 12 dont il faut assurer le contact. Selon cette technique, et selon la nature du polymère, on peut avoir un effet adhésif du polymère sur la surface du plot à contacter. Par contre, cet effet adhésif ne s'obtient que sur la surface de ce plot, et pas entre les plots (dans les intervalles 35, 37, par exemple). En outre, la préparation du polymère dans lequel on évapore un matériau fusible pour réaliser les clous doit être préalablement réalisée sur un support. Il faut ensuite décoller la couche de polymère de ce support, sans enlever le matériau fusible 36, ce qui suppose un procédé à froid. Enfin, la liaison reste de type "contact", car elle est obtenue par écrasement des clous sur les plots ; par conséquent, même avec un matériau fusible, le contact reste médiocre.

Le document EP-213 774 décrit une feuille de matériau isolante, poreuse, les pores contenant un matériau conducteur établissant une liaison conductrice entre les surfaces de la feuille, et se projetant au-delà d'au moins une des surfaces de la feuille. Ce document ne divulgue que des structures tubulaires, ainsi que des structure pouvant être en un seul matériau, mais dépassant des surfaces de la feuille.

Le document EP-327 399 décrit un film conducteur pour connecter un substrat et un circuit. Le film conducteur est percé de trous à travers lesquels la liaison électrique est établie entre les deux éléments à relier. Ce document décrit d'abord un film comportant des trous dont l'intérieur est métallisé, de façon à établir un chemin électrique d'une surface à l'autre de la couche. Les parois internes du trou peuvent être recouvertes d'une couche métallique, formant ainsi un tube à l'intérieur duquel un matériau fusible, par exemple de la soudure, peut être introduit. La figure 9 de ce document décrit le dépôt d'une couche supplémentaire de métal, par exemple de l'or, par dessus les conducteurs métalliques disposés dans les trous. Ces conducteurs débordent des trous après qu'une ou plusieurs couches superficielles de polymère aient été enlevées. Le dépôt supplémentaire de métal sert de collier pour obtenir le matériau métallique dans les trous.

Le document EP-560 072 décrit un film conducteur anisotrope présentant des trous remplis par une substance métallique, sous forme de clous ou de rivets. La substance métallique peut être de l'or, de l'argent, du cuivre, etc. ou des alliages de différents métaux. Ce document décrit également un procédé pour réaliser un film conducteur anisotrope, mais les clous sont constitués d'un seul matériau, qui est celui de la partie centrale.

### Exposé de l'invention

La présente invention propose un film polymère anisotrope dont le décollement est aisé lors de sa préparation et qui assure une meilleure liaison que la liaison par contact lors de l'assemblage d'une puce et d'un substrat.

La solution à ces problèmes consiste à réaliser dans le film des clous comportant différents matériaux ayant des températures de fusion différentes selon les revendications 1 et 11.

Plus spécifiquement, l'invention a pour objet un film conducteur anisotrope autoporté comportant une couche de polymère contenant des trous traversants, des éléments conducteurs en forme de clou remplissant ces trous traversants et comportant une partie centrale et des extrémités, la partie centrale des clous étant constituée d'un matériau conducteur dur et chaque extrémité respectivement d'un premier et d'un second matériaux fusibles.

De façon avantageuse, le premier et/ou le deuxième matériaux sont débordants de part et d'autre de la couche de polymère.

Selon un mode particulier de réalisation de l'invention, les premier et second matériaux fusibles sont identiques.

Ainsi qu'il sera expliqué plus loin, ce film conducteur anisotrope permet de réaliser des contacts puce-substrat présentant une faible résistance électrique, une bonne solidité mécanique et une bonne fiabilité.

Pour le matériau dur, il est possible de choisir du cuivre ou du nickel ou éventuellement un autre matériau fusible.

On peut choisir, comme matériau fusible, du SnPb.

Les trous traversants peuvent être espacés d'une distance comprise entre 3 et 500µm, le diamètre des trous pouvant varier d'environ 1 à 100µm.

La réalisation de trous avec ce pas faible permet de réaliser un film conducteur anisotrope "universel", qui peut s'adapter à différents types de structures à connecter.

La présente invention a également pour objet un procédé de réalisation d'un film conducteur anisotrope tel que décrit ci-dessus, ce procédé étant caractérisé en ce que :
- on dépose sur un substrat une couche d'un premier matériau fusible,
- on dépose une couche de polymère sur la couche de premier matériau fusible,
- on effectue un recuit de cette couche de polymère,
- on forme des trous traversants dans la couche de polymère,
- on dépose un matériau conducteur dur dans les trous,
- on dépose un deuxième matériau fusible sur le matériau dur,
- on chauffe à une température supérieure ou égale à la température de fusion du premier matériau fusible, et on décolle ainsi le film conducteur anisotrope du substrat.

Ce procédé présente l'avantage de permettre un décollement facile, à partir du substrat, du film conducteur anisotrope formé. Le premier matériau fusible, qui n'a pas d'affinité chimique avec le polymère, fond et permet un décollement du film aisé. De plus, on obtient alors une brasure du matériau fusible sur le matériau dur, et, donc, une structure de clou très bien implantée mécaniquement dans le film décollé.

Selon un mode particulier de réalisation de l'invention, on dépose sur le substrat, préalablement au dépôt de la couche de premier matériau fusible, une couche d'accrochage de ce premier matériau fusible.

Les deux matériaux fusibles peuvent être identiques.

De plus, un autre aspect de l'invention permet de résoudre le problème du caractère partiel de l'effet adhésif du polymère entre un substrat et une puce, dans le cas d'un polymère selon l'art antérieur; Pour résoudre ce problème, l'étape de recuit du polymère est un recuit partiel. Ceci permet d'assurer un fluage du polymère lors de l'assemblage.

L'invention a également pour objet une utilisation d'un film tel que décrit ci-dessus, pour relier une puce et un substrat présentant chacun des plots conducteurs, et caractérisée en ce que :
- on dépose le film conducteur anisotrope sur le substrat, de façon à ce que des parties en matériau fusible soient en contact avec les plots du substrat,
- on dépose la puce sur le film conducteur de façon à ce que des parties fusibles soient en contact avec les plots de la puce et de façon à ce que les plots de la puce soient en regard de ceux du substrat,
- on recuit l'ensemble à une température permettant la brasure des premier et second matériaux fusibles sur les plots.

L'ordre des étapes de dépôt du film conducteur sur le substrat puis sur la puce peut être inversé.

D'autres aspects de l'invention apparaissent dans les revendications dépendantes.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- les figures 1 à 5, déjà décrites, représentent des liaisons par film conducteur anisotrope selon l'art antérieur,
- les figures 6a à 6f illustrent des étapes d'un procédé de réalisation d'un film conducteur anisotrope selon la présente invention,
- les figures 7a à 7c illustrent des étapes d'assemblage d'une puce sur un substrat par l'intermédiaire d'un film conducteur anisotrope selon la présente invention.

### Description détaillée de modes de réalisation de l'invention

Un procédé de préparation d'un film conducteur anisotrope selon la présente invention est illustré sur les figures 6a à 6f.

Dans une première étape (figure 6a), on dépose sur un substrat 40 une couche d'accrochage 42 d'un premier matériau fusible, cette couche étant constituée par exemple de TiNiAu, formée par exemple par pulvérisation cathodique ou évaporation et d'épaisseur comprise par exemple entre 0,1µm et 5µm. Sur cette couche 42, on dépose une couche d'un premier matériau fusible 44, et enfin une couche de polymère 46 : par exemple un polyimide, une résine, une colle, ou un matériau thermoplastique. Cette couche 46 est recuite, avantageusement partiellement, en lui faisant subir, par exemple dans le cas d'un polyimide un prétraitement thermique de 200°C pendant 5 minutes. Cette dernière couche 46 a par exemple une épaisseur d'environ 10µm. Si le matériau fusible peut accrocher directement sur le substrat 40, il est alors possible d'éviter le dépôt de la couche d'accrochage 42.

Puis, (figure 6b), un masque 48 de résine réalisé par exemple par lithographie est formé sur la couche polymère 46. Une gravure de la couche polymère est ensuite réalisée (figure 6c), permettant de dégager des trous 50 traversant la couche de polymère 46. Le masque 48 est ensuite enlevé (figure 6d) et il est procédé (figure 6e) à un dépôt, par électrolyse, dans les trous 50, d'un matériau dur 52 tel que par exemple du cuivre ou du nickel ou encore un matériau fusible à haute température tel que du SnPb(5-95). Le matériau dur est un matériau qui présente une température de fusion supérieure à celle du premier matériau fusible, et préférentiellement à celle d'élaboration du polymère et à celle utilisée pour le décollement du film. Ensuite, on dépose sur le matériau dur 52 une couche d'un second matériau fusible 54, et ceci également par électrolyse. Les électrolyses utilisent comme électrode la couche continue sous-jacente de premier matériau fusible. Après dépôt de cette couche 54, on chauffe l'ensemble à une température T supérieure ou égale à la température de fusion du premier matériau fusible. Ceci conduit d'une part à un décollement de la couche 42 et des parties de la couche du premier matériau fusible 44 qui ne sont pas en contact avec le matériau dur 52 et, d'autre part, à la brasure du matériau fusible 44 sur le matériau dur 52.

Il peut y avoir retrait du polymère 46 lorsque celui-ci n'a pas été complètement recuit avant le décollement et lorsque la température de décollement est supérieure à la température de prérecuit.

Les matériaux fusibles peuvent être choisis de même nature, par exemple du SnPb à 60-40% pour les premier et second matériaux fusibles et, pour la partie dure et rigide du clou, du SnPb à 5-95%. Le premier (SnPb à 60-40%) est un matériau fusible basse température (180°C) et le second (SnPb à 5-95%) est un matériau fusible haute température (340°C). D'une façon générale, lorsque la partie rigide du clou est réalisée en matériau fusible, c'est par exemple un matériau fusible à haute température de façon à ce que sa température de fusion soit supérieure à la température T utilisée pour réaliser, par refonte du premier matériau fusible, le décollement de la couche 42 et le retrait du polymère 46. Ceci permet d'éviter, lors du décollement à la température T, un arrachement de la partie rigide du clou et que des ouvertures apparaissent dans le film.

Au cours de l'étape de séparation du substrat 40, le matériau dur (par exemple en Cu, Ni ou, dans le cas décrit précédemment SnPb(5-95)) s'allie avec les portions de matériau fusible 44 et éventuellement 54 avec lesquelles il est en contact. On obtient ainsi des clous 51, chaque clou ayant une partie centrale dure 52 et une finition fusible à ses deux extrémités. En outre, si l'on prend soin, en choisissant correctement la température T permettant le décollement et la durée pendant laquelle on chauffe à cette température T, de ne pas dépasser la température à laquelle le polymère est complètement polymérisé, ce dernier conserve une certaine souplesse.

Le film obtenu est autoporté : il y a indépendance mécanique du film par rapport à toute autre structure, notamment par rapport aux structures à connecter ultérieurement.

La partie centrale des clous, en matériau dur, est noyée dans le polymère : elle n'en déborde pas.

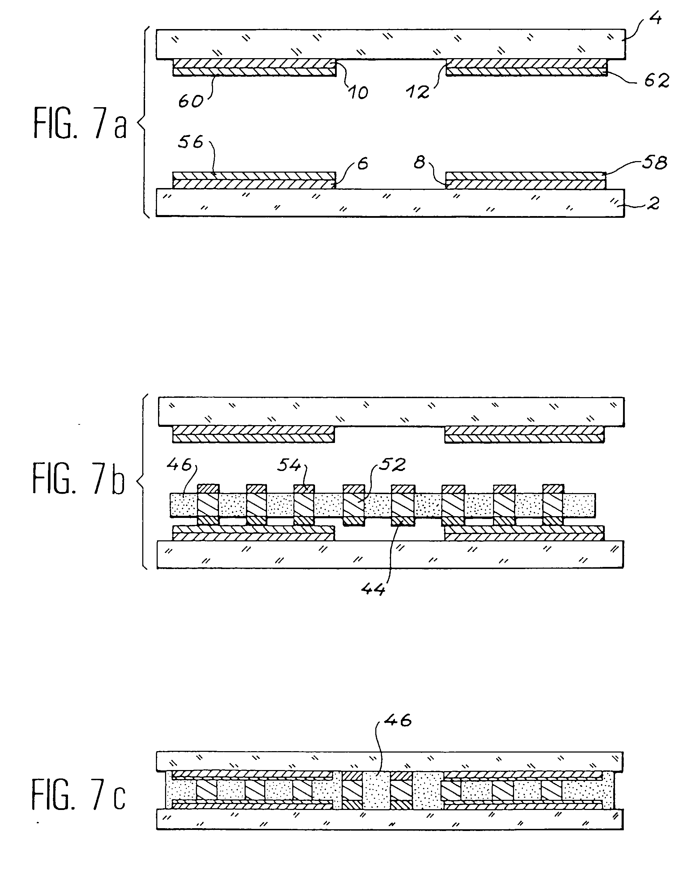

Le processus d'assemblage d'un substrat et d'une puce, tous deux munis de plots de contact, à l'aide d'un film conducteur anisotrope tel que décrit ci-dessus, va maintenant être exposé. Ce procédé est illustré, pour certaines de ses étapes, sur les figures 7a à 7c. On considère donc un substrat 2 muni de plots 6, 8 en regard ou alignés en face de plots 10, 12 d'une puce 4. Ces plots sont par exemple en aluminium. Il peut être avantageux de recouvrir ces plots de couches d'accrochage 56, 58, 60, 62 pour braser ou accrocher les matériaux fusibles 44, 54. A titre d'exemple, on peut réaliser, à l'aide d'un procédé "ELECTROLESS", une bi-couche Ni-Au ou NiAg ou NiSn ou encore (CrCu)-Cu qui fait office de barrière de diffusion et de matériau brasable par les matériaux fusibles 44, 54 des clous 51. Si, par contre, les matériaux fusibles 44, 54 peuvent être brasés directement sur les plots, une telle couche d'accrochage n'est pas nécessaire.

Comme illustré sur la figure 7b, les deux éléments (substrat et puce) sont ensuite disposés face à face, avec les plots alignés ou en regard les uns en face des autres, et on interpose entre les deux une couche de film conducteur anisotrope telle que celle qui a été décrite ci-dessus.

Enfin (figure 7c) l'ensemble est soumis à une température d'assemblage supérieure ou égale aux :
- températures de fusion des deux matériaux fusibles si le polymère était préalablement totalement polymérisé,
- températures de fusion des deux matériaux fusibles et à la température de polymérisation finale du polymère si ce dernier n'était pas préalablement totalement polymérisé.

La température d'assemblage peut par exemple se situer entre 200°C et 450°C, par exemple aux alentours de 350°C.

Eventuellement, l'ensemble est soumis à une pression, par exemple comprise entre 0,1 et 10kg/cm².

Cette étape conduit, si le polymère était préalablement complètement polymérisé, à une brasure des matériaux fusibles et une compression des plots. La partie fusible des clous qui est en contact avec la couche d'accrochage présente sur les plots, s'allie avec celle-ci : cela se traduit par une diminution de la hauteur des clous situés entre un plot de la puce et un plot du substrat. Cette hauteur est ramenée approximativement à la hauteur de la partie centrale du clou en matériau dur 52. Pour les autres clous, qui ne sont pas en regard d'une métallurgie d'accrochage, ce phénomène ne se produit pas.

On obtient ainsi une connexion électrique assurée par une véritable brasure entre un matériau fusible et une surface soudable.

Si le polymère n'était pas préalablement totalement recuit ou polymérisé, cette étape conduit à la polymérisation finale du polymère, à une brasure des matériaux fusibles et une compression des plots et à un collage du matériau polymère avec les différentes surfaces. Pendant l'assemblage, et sous l'effet de la température et éventuellement de la pression, le polymère, jusqu'ici incomplètement recuit, flue et peut compenser les défauts de reliefs des plots. Ceci permet en outre d'accroître la surface de contact entre le polymère et les structures à assembler et ainsi d'améliorer la tenue mécanique. La partie fusible des clous qui est en contact avec la couche d'accrochage présente sur les plots, s'allie avec celle-ci : cela se traduit par une diminution de la hauteur des clous situés entre un plot de la puce et un plot du substrat. Cette hauteur est ramenée approximativement à la hauteur de la partie centrale du clou en matériau dur 52. Pour les autres clous, qui ne sont pas en regard d'une métallurgie d'accrochage, ce phénomène ne se produit pas.

On obtient ainsi une connexion électrique assurée par une véritable brasure entre un matériau fusible et une surface soudable. Cette connexion présente une résistance électrique très faible (de l'ordre de quelques mΩ) et une très grande solidité mécanique.

Si le polymère est un matériau thermoplastique l'assemblage est réversible : il suffit de chauffer l'ensemble jusqu'à la température de ramolissement du polymère, puis de dissocier les deux parties.

Selon un exemple de réalisation, les caractéristiques suivantes ont été obtenues :
- diamètre des clous 10 µm,
- pas du matriçage des clous : 40 µm,
- matériaux utilisés : pour le matériau dur des clous, du cuivre ou du nickel ; pour les premier et second matériaux fusibles, du SnPb 60-40,
- épaisseur de la couche de polymère initiale : 20µm ; après assemblage :10µm. Nature du polymère : type CEMOTA Syntorgip 305/20 (polyimide),
- dépôt de la couche 46 de polyimide sur la couche de premier matériau fusible 44, avec prérecuit à 180°C pendant 4 minutes,
- température T à laquelle on décolle la couche 46 (figure 6e) : T=230°C, pendant 30 secondes,
- dépôt d'une couche d'accrochage sur les plots de la puce et du substrat à interconnecter, en NiAu ou (CrCu)-Cu,
- conditions d'assemblage substrat-puce : température de 350°C, pendant 20 minutes, plus une pression (facultative) de 1kg/cm².

Il est possible, généralement, de choisir comme polymère une résine ou une colle polymère ou un polyimide.

De préférence, on utilise un polymère présentant les propriétés suivantes :
- léger retrait lors de la réticulation finale,
- minimum de libération de solvant pendant les phases d'élévation de la température (recuits),
- cycles de recuits adaptés aux matériaux fusibles employés (notamment, tenue du polymère à des températures élevées, pouvant atteindre 350°C).

Les polyimides présentent toutes ces propriétés et constituent donc un type de polymère particulièrement bien adapté à l'invention.

Il peut être avantageux, dans certains cas, d'enduire de colle (ou, lorsque le polymère est un polyimide, d'un mélange polyimide-solvant) le polymère et/ou les structures à assembler pour améliorer encore l'adhérence de l'ensemble.

## Revendications

1. Film conducteur anisotrope autoporté caractérisé en ce qu'il comporte une couche (46) de polymère contenant des trous traversants (50), des éléments conducteurs en forme de clou (51) remplissant ces trous traversants, chaque clou comportant une partie centrale et des extrémités juxtaposées à la partie centrale :
- chaque extrémité étant constituée respectivement d'un premier et d'un second matériaux fusibles (44, 54),
- la partie centrale des clous étant pleine et constituée d'un matériau (52) dont la température de fusion est supérieure à celle du premier et du second matériau fusible, et cette partie centrale ne débordant pas de la couche de polymère.

2. Film conducteur selon la revendication 1, le premier et/ou le second matériaux fusibles étant débordants de part et d'autre de la couche polymère.

3. Film conducteur anisotrope selon la revendication 1, les deux matériaux fusibles étant identiques.

4. Film conducteur selon la revendication 1, le matériau dont la température de fusion est supérieure à celle du premier matériau fusible étant un matériau fusible.

5. Film conducteur anisotrope selon l'une des revendications 1 à 4, le matériau dont la température de fusion est supérieure à celle du premier matériau fusible étant du cuivre ou du nickel.

6. Film conducteur anisotrope selon l'une des revendications précédentes, les matériaux fusibles étant du SnPb.

7. Film conducteur anisotrope selon l'une des revendications précédentes, les trous traversants étant espacés d'une distance comprise entre 3 et 500µm.

8. Film conducteur anisotrope selon l'une des revendications précédentes, le diamètre des trous étant compris entre 1 à 100µm.

9. Film conducteur anisotrope selon l'une des revendications précédentes, l'épaisseur de la couche polymère (46) étant comprise entre 5 et 200 µm.

10. Film conducteur anisotrope selon l'une des revendications 1 à 9, la couche de polymère étant réalisée en plusieurs couches.

11. Procédé de réalisation d'un film conducteur anisotrope selon l'une des revendications précédentes, caractérisé en ce que :
- on dépose sur un substrat (40) une couche (44) d'un premier matériau fusible,
- on dépose une couche de polymère (46) sur la couche de premier matériau fusible,
- on effectue un recuit de cette couche polymère,
- on forme des trous (50) traversants dans la couche de polymère,
- on dépose un matériau conducteur (52) de température de fusion supérieure à celle du premier et du second matériau fusible dans les trous, de manière à former une partie pleine ne débordant pas de la couche de polymère, ce matériau constituant la partie centrale des clous,
- on dépose un deuxième matériau fusible (54) sur le matériau dont la température de fusion est supérieure à celle du premier matériau fusible, les premier et deuxième matériaux fusibles constituant les extrémités des clous,
- on chauffe à une température T supérieure ou égale à la température de fusion du premier matériau fusible, et on décolle le film conducteur anisotrope du substrat.

12. Procédé selon la revendication 11, dans lequel on dépose sur le substrat, préalablement au dépôt de la couche de premier matériau fusible, une couche d'accrochage (42) du premier matériau fusible (44).

13. Procédé selon la revendication 12, la couche d'accrochage étant en TiNiAu.

14. Procédé selon l'une des revendications 11 à 13, les premier et second matériaux fusibles étant identiques.

15. Procédé selon l'une des revendications 11 à 14, le matériau dont la température de fusion est supérieure à celle du premier matériau fusible étant choisi parmi Cu, Ni, SnPb (5-95).

16. Procédé selon l'une des revendications 11 à 15, les premier et second matériaux fusibles étant du SnPb 60-40.

17. Procédé selon l'une des revendications 11 à 16, dans lequel le matériau dont la température de fusion est supérieure à celle du premier matériau fusible et le premier matériau fusible sont formés par électrolyse en utilisant le premier matériau comme électrode.

18. Procédé selon l'une des revendications 11 à 17, le recuit de la couche polymère étant partiel.

19. Procédé pour connecter une puce (4) et un substrat (2) présentant chacun des plots (6, 8, 10, 12) conducteurs, caractérisée en ce que :
- on dépose un film conducteur anisotrope, selon l'une des revendications 1 à 10, sur le substrat (2), de façon à ce que des parties (44) en matériau fusible soient en contact avec les plots (6, 8) du substrat,
- on dépose la puce sur le film conducteur de façon à ce que des parties fusibles (54) du film conducteur anisotrope soient en contact avec les plots de la puce, et à ce que les plots de la puce soient en regard ou alignés avec ceux du substrat,
- on recuit l'ensemble à une température permettant la brasure des premier et second matériaux fusibles sur les plots.

20. Procédé selon la revendication 19, une couche (56, 58, 60, 62) d'accrochage des matériaux fusibles étant préalablement déposée sur les plots du substrat et/ou de la puce.

21. Procédé selon la revendication 20, la couche d'accrochage étant en NiAu.

22. Procédé selon l'une des revendications 19 ou 20, la température de recuit de l'ensemble étant choisie de façon à faire fluer le polymère et à permettre sa polymérisation finale.

## Patentansprüche

1. Selbsttragende anisotropische Leiterschicht,
**dadurch gekennzeichnet**,
dass sie eine Polymerschicht (46) umfasst, die durchgehende Löcher (50) und diese durchgehenden Löcher ausfüllende Elemente (51) mit der Form von Nägeln enthält und dabei jeder Nagel einen Mittelteil und an den Mittelteil angrenzende Enden umfasst, wobei:
- jedes Ende jeweils durch ein erstes und ein zweites schmelzbares Material (44, 54) gebildet wird,
- der Mittelteil der Nägel voll bzw. massiv ist und durch ein Material (52) gebildet wird, dessen Schmelztemperatur höher als die des ersten und zweiten schmelzbaren Materials ist, und dieser Mittelteil nicht aus der Polymerschicht vorsteht.

2. Anisotropische Leiterschicht nach Anspruch 1, wobei das erste und das zweite schmelzbare Material beiderseits der Polymerschicht übersteht.

3. Anisotropische Leiterschicht nach Anspruch 1, wobei die beiden schmelzbaren Materialien identisch sind.

4. Anisotropische Leiterschicht nach Anspruch 1, wobei das Material, dessen Schmelztemperatur höher als die des ersten schmelzbaren Materials ist, ein schmelzbares Material ist.

5. Anisotropische Leiterschicht nach einem der Ansprüche 1 bis 4, wobei das Material, dessen Schmelztemperatur höher als die des ersten schmelzbaren Materials ist, Kupfer oder Nickel ist.

6. Anisotropische Leiterschicht nach einem der vorangehenden Ansprüche, wobei die schmelzbaren Materialien SnPb sind.

7. Anisotropische Leiterschicht nach einem der vorangehenden Ansprüche, wobei die durchgehenden Löcher um eine Distanz beabstandet sind, die zwischen 3 und 500µm enthalten ist.

8. Anisotropische Leiterschicht nach einem der vorangehenden Ansprüche, wobei der Durchmesser der Löcher zwischen 1 und 100µm enthalten ist.

9. Anisotropische Leiterschicht nach einem der vorangehenden Ansprüche, wobei die Dicke der Polymerschicht (46) zwischen 5 und 200 µm enthalten ist.

10. Anisotropische Leiterschicht nach einem der Ansprüche 1 bis 9, wobei die Polymerschicht durch mehrere Schichten gebildet wird.

11. Herstellungsverfahren einer anisotropischen Leiterschicht nach einem der vorangehenden Ansprüche,
**dadurch gekennzeichnet**, dass:
- man auf einem Substrat (40) eine Schicht (44) eines ersten schmelzbaren Materials abscheidet,
- man auf der Schicht aus dem ersten schmelzbaren Material eine Polymerschicht (46) abscheidet,
- man ein Tempern dieser Polymerschicht durchführt,
- man in der Polymerschicht durchgehende Löcher (50) bildet,
- man in den Löchern ein leitfähiges Material (52) mit einer höheren Schmelztemperatur als der des ersten und zweiten Materials abscheidet, um einen vollen bzw. massiven Teil zu bilden, der nicht aus der Polymerschicht vorsteht, wobei dieser Teil den Mittelteil der Nägel bildet,
- man ein zweites schmelzbares Material (54) auf dem Material abscheidet, dessen Schmelztemperatur höher ist als die des ersten schmelzbaren Materials, wobei das erste und das zweite schmelzbare Material die Enden der Nägel bilden,
- man auf eine Temperatur T erwärmt, die höher oder gleich der Schmelztemperatur des ersten schmelzbaren Materials ist, und man die anisotropische Leiterschicht von dem Substrat löst.

12. Verfahren nach Anspruch 11, wobei man vor dem Abscheiden der Schicht aus dem ersten schmelzbaren Material auf dem Substrat eine Haftschicht (42) für das erste schmelzbare Material (44) abscheidet.

13. Verfahren nach Anspruch 12, wobei die Haftschicht aus TiNiAu ist.

14. Verfahren nach einem der Ansprüche 11 bis 13, wobei das erste und das zweite schmelzbare Material identisch sind.

15. Verfahren nach einem der Ansprüche 11 bis 14, wobei das Material, dessen Schmelztemperatur höher als die des ersten schmelzbaren Materials ist, unter Cu, Ni, SnPb (5-95) ausgewählt wird.

16. Verfahren nach einem der Ansprüche 11 bis 15, wobei das erste und das zweite schmelzbare Material SnPb (60-40) ist.

17. Verfahren nach einem der Ansprüche 11 bis 16, bei dem das Material, dessen Schmelztemperatur höher als die des ersten schmelzbaren Materials ist und das erste schmelzbare Material durch Elektrolyse gebildet werden, wobei man das erste Material als Elektrode benutzt.

18. Verfahren nach einem der Ansprüche 11 bis 17, wobei das Tempern der Polymerschicht partiell ist.

19. Verfahren zum Verbinden eines Chips (4) und eines Substrats (2), die beide leitfähige Kontaktflächen (6, 8, 10, 12) aufweisen,
**dadurch gekennzeichnet**, dass:
- man eine anisotropische Leiterschicht nach einem der Ansprüche 1 bis 10 derart auf dem Substrat (2) abscheidet, dass Teile (44) aus schmelzbarem Material Kontakt haben mit den Kontaktflächen (6, 8) des Substrats,
- man den Chip derart auf der Leiterschicht anbringt, dass die schmelzbaren Teile (54) der anisotropischen Leiterschicht Kontakt haben mit den Kontaktflächen des Chips, und dass die Kontaktflächen des Chips denen des Substrats gegenüberstehen oder mit ihnen fluchten,
- man das Ganze bei einer Temperatur tempert, die die Lötung des ersten und des zweiten schmelzbaren Materials auf die Kontaktflächen ermöglicht.

20. Verfahren nach Anspruch 19, wobei eine Haftschicht (56, 58, 60, 62) der schmelzbaren Materialien vorher auf den Kontaktflächen des Substrats und/oder des Chips abgeschieden wird.

21. Verfahren nach Anspruch 20, wobei die Haftschicht aus NiAu ist.

22. Verfahren nach einem der Ansprüche 19 oder 20, wobei die Tempertemperatur gewählt wird, um das Polymer fließen zu lassen und seine Endpolymerisation zu ermöglichen.

## Claims

1. Self-supported, anisotropic, conductive film having a polymer layer (46) containing through holes (50), nail-shaped conductive elements (51) filling said through holes, each nail incorporating a central part and ends juxtaposed to the central part:
- each end being constituted respectively by a first and a second meltable materials (44, 54),
- the central part of the holes being solid and constituted by a material (52), whose melting point is higher than that of the first and second meltable materials and said central part does not project beyond the polymer layer.

2. Conductive film according to claim 1, the first and/or second meltable materials projecting on either side of the polymer layer.

3. Anisotropic conductive film according to claim 1, the two meltable materials being identical.

4. Conductive film according to claim 1, the material whose melting point is higher than that of the first meltable material being a meltable material.

5. Anisotropic conductive film according to one of the claims 1 to 4, the material whose melting point is higher than that of the first meltable material being of copper or nickel.

6. Anisotropic conductive film according to one of the preceding claims, the meltable materials being of SnPb.

7. Anisotropic conductive film according to one of the preceding claims, the through holes being spaced by a distance between 3 and 500 µm.

8. Anisotropic conductive film according to one of the preceding claims, the diameter of the holes being between 1 and 100 µm.

9. Anisotropic conductive film according to one of the preceding claims, the thickness of the polymer layer being between 5 and 200 µm.

10. Anisotropic conductive film according to one of the claims 1 to 9, the polymer layer being in the form of several layers.

11. Process for the production of an anisotropic conductive film according to one of the preceding claims, characterized in that:
- a layer (44) of a first meltable material is deposited on a substrate (40), a polymer layer (46) is deposited on the first meltable material layer,
- the polymer layer is annealed,
- through holes (50) are formed in the polymer layer,
- a conductive material (52) having a higher melting point to that of the first and second meltable materials is deposited in the holes, so as to form a solid part not projecting beyond the polymer layer, said material constituting the central part of the nails,
- a second meltable material (54) is deposited on the material whose melting point is higher than that of the first meltable material, the first and second meltable materials constituting the ends of nails,
- heating takes place to a temperature T equal to or higher than the melting point of the first meltable material and the anisotropic conductive film is separated from the substrate.

12. Process according to claim 11, in which deposition takes place on the substrate, prior to the deposition of the first meltable material layer, of an attachment layer (42) of the first meltable material (44).

13. Process according to claim 12, the attachment layer being of TiNiAu.

14. Process according to one of the claims 11 to 13, the first and second meltable materials being identical.

15. Process according to one of the claims 11 to 14, the material whose melting point is higher than that of the first meltable material being chosen from among Cu, Ni, SnPb (5-95).

16. Process according to one of the claims 11 to 15, the first and second meltable materials being of SnPb (60-40).

17. Process according to one of the claims 11 to 16, in which the material whose melting point is higher than that of the first meltable material and the first meltable material are formed by electrolysis using the first material as the electrode.

18. Process according to one of the claims 11 to 17, the annealing of the polymer layer being partial.

19. Process for connecting a chip (4) and a substrate (2), each having conductive pads (6, 8, 10, 12), characterized in that:
- the anisotropic conductive film, according to one of the claims 1 to 10, is deposited on the substrate (2) in such a way that meltable material parts (44) are in contact with the pads (6, 8) of the substrate,
- the chip is deposited on the conductive film in such a way that meltable parts (54) of the anisotropic conductive film are in contact with the pads of the chip and the pads of the chip face or are aligned with those of the substrate,
- the assembly is annealed at a temperature permitting the brazing of the first and second meltable materials on the pads.

20. Process according to claim 19, a meltable material attachment layer (56, 58, 60, 62) having been previously deposited on the pads of the substrate and/or the chip.

21. Process according to claim 20, the attachment layer being of NiAu.

22. Process according to one of the claims 19 or 20, the annealing temperature of the assembly being chosen in such a way as to make the polymer creep and permit its final polymerization.
